# EUROPEAN PATENT APPLICATION

(11) **EP 3 226 317 A1**
(43) Date of publication of application: **04.10.2017**
(21) Application number: 17160621.3
(22) Date of filing: 13.03.2017
(51) Int. Cl.: H01L 51/46, H01L 27/30

(54) **LARGE-AREA PEROVSKITE FILM AND PEROVSKITE SOLAR CELL OR MODULE AND FABRICATION METHOD THEREOF**

(30) Priority: 01.04.2016 TW 105110613
(71) Applicant: National Central University, Taoyuan City 32001 (TW)
(72) Inventor: Wu, Chun-Guey, 970 Hualien City (TW); CHIANG, Chien-Hung, 701 Tainan City (TW)
(74) Representative: Zinkler, Franz

(57) **Abstract**

A method of fabricating a large-area perovskite film includes steps of: providing a precursor solution on a conductive substrate to form a film, wherein the perovskite is represented by a formula of ABX₃, and the solutes of the precursor solution at least comprises A, B and X; and applying an anti-solvent or Infrared light on the film. The fabrication methods of a large-area perovskite film and a perovskite solar cell or module are also disclosed.

## Description

### BACKGROUND OF THE INVENTION

### Field of Invention

The present invention relates to a perovskite film, a perovskite solar cell or module and fabrication method thereof. In particular, the present invention relates to a large-area perovskite film, a large-area perovskite solar cell or module and fabrication method thereof.

### Related Art

In the recent years the consumption of energies, especially the petrochemical and coal energies, is continuously increasing, which causes the global warming, climate change, and a lot of disasters. Thus, it is desirable to develop an environmental friendly alternative energy sources. The available alternative renewable energy sources include hydraulic, wind, tidal, solar and geothermal energies. Among these alternative renewable energy sources, solar energy is one of the best sources. Therefore, the energy converted from Sun to electricity by solar cell which has the advantages of low pollution, less environmental restrictions and high safety, is the most popular technology.

Perovskite solar cell has a perovskite film as an active layer (or light absorption layer). Perovskite has a high light absorption coefficient and wide absorption band. Furthermore, solar cell with the active layer containing a thin perovskite film can produce high short-circuit current and high open-circuit voltage. Accordingly, the perovskite solar cell achieves an excellent power conversion efficiency (PCE). In addition, since the perovskite film in perovskite solar cell is very thin, so the active material cost is low.

However, it is difficult to fabricate large-area (> 1 cm²) perovskite film with good continuity, uniformity and containing large grains for perovskite solar cell or module so far. The defects (holes, grain boundaries) of the perovskite film will cause the current leakage, therefore decreasing the power conversion efficiency (PCE) of the solar cell or module and will show current hysteresis. Herein, the current hysteresis means that the I-V curves of the solar cell or module from the forward and reverse sweeps are not overlapped.

Therefore, it is an important subject of this invention to provide a method to prepare a high quality (smooth, uniform and no hole), large-area perovskite film to be applied to the perovskite solar cell or module to achieve high PCE to realize the commercialization of this technology.

### SUMMARY OF THE INVENTION

An objective of the present invention is to provide a method of fabricating a large-area, continuous and uniform perovskite film and a perovskite solar cell or module.

In one embodiment, the present invention discloses a method of fabricating a high quality, large-area perovskite film, which includes the following steps: providing a precursor solution on a conductive substrate by slot die coating to form a film, wherein a perovskite is represented by a formula of ABX₃, and the solutes of the precursor solution at least comprises A, B and X; and immersing the film in an anti-solvent or heating the film with Infrared light so as to form the perovskite film. The grains of the perovskite crystals on the perovskite film are continuous and evenly distributed on the conductive substrate, and the areas of the perovskite film as well as the conductive substrate are 5∼10000 cm².

In one embodiment, the anti-solvent induces the film to form perovskite crystals. Herein, A is at least one of alkali metal ions, CH₃NH₃⁺, and NH₂CH= NH₂⁺, B is at least one of Pb, Sn, and Ge, and X is at least one of halogen (F, Cl, Br or I), PF₆, and SCN.

In one embodiment, the anti-solvent is a single solvent.

In one embodiment, the wavelength of the Infrared light is 750 nm ∼ 2000 nm.

In one embodiment, the solvent of the precursor solution is DMF, DMSO, GBL, or their mixture thereof.

In one embodiment, the anti-solvent is thiophene and its derivative, iodobenzene, ether, CB (chlorobenzene), DCB (dichlorobenzene), toluene, benzene, or their mixtures.

In one embodiment, the method of fabricating a large-area perovskite film further includes a step of: annealing the film so as to grow big perovskite crystals.

In one embodiment, the anti-solution is applied on the film by spin coating, slot die coating, ink-jet printing, printing, or daubing, and a generating speed of perovskite crystals in the film depends on the speed of applying the anti-solution on the film.

In one embodiment, the film is immersed in the anti-solvent so as to apply the anti-solvent on the film, and an amount of perovskite crystals generated in the film depends on an immersion time of the film in the anti-solvent.

The present invention also discloses a method of fabricating a large-area perovskite solar cell or module, which includes the following steps of: providing a conductive substrate; forming a first carrier transport layer on the conductive substrate; providing a precursor solution on the first carrier transport layer by slot die coating to form a film, wherein a perovskite is represented by a formula of ABX₃, and the solutes of the precursor solution at least comprises A, B and X; immersing the film in an anti-solvent or irradiating with the Infrared light to transform the film into a perovskite film; annealing the film to grow perovskite crystals; forming a second carrier transport layer on the perovskite film; and forming an electrode layer on the second carrier transport layer. The perovskite crystals of the perovskite film are continuously and evenly distributed on the conductive substrate, and the areas of the perovskite film and the conductive substrate are 5∼10000 cm².

In one embodiment, the method of fabricating a large-area perovskite solar cell or module utilizes the above-mentioned method to fabricate a large-area perovskite film on the conductive substrate.

In one embodiment, the conductive substrate is a transparent conductive glass or a flexible transparent conductive substrate.

In one embodiment, the first carrier transporting layer is a hole transporting layer or an electron transporting layer, while the second carrier is an electron transporting layer or a hole transporting layer, and the electrode layer is a cathode layer or an anode layer.

In one embodiment, the hole transporting layer includes one or any combinations of PEDOT:PSS, V₂O₅, In₂O₃, NiO, graphene, MoS, MoSe, Spiro-OMeTAD, polyalkyl-thiophene, and MoO₃.

In one embodiment, the electron transporting layer includes one or any combinations of 6,6-phenyl-C61-butyric acid methyl ester (PC₆₁BM), 6,6-phenyl-C71-butyric acid methyl ester, (PC₇₁BM), Indene-C60 bisadduct (ICBA), C₆₀, C₇₀, LiF, Ca, TiO₂, Bathocuproine (BCP), ZrO, ZnO, polyethylenimine (PEI), and poly[(9,9-bis(3'-(N,N-dimethylamino)propyl)-2,7-fluorene)-alt-2,7-(9,9-dioctyl-fluore ne) (PFN).

In one embodiment, the electrode layer includes one or any combinations of Ca, Al, Ag, Pd, and Au.

The present invention further discloses a large-area perovskite solar cell or module including a conductive substrate, a first carrier transporting layer, a perovskite film, a second carrier transporting layer and an electrode layer. The conductive substrate has an area ranged from 5 cm² to 10000 cm². The first carrier transporting layer is deposited on the conductive substrate. The perovskite film has a continuous and smooth surface with a film area greater than 5 cm². The second carrier transporting layer is deposited on the perovskite film, and the electrode layer is deposited on the second carrier transporting layer.

In one embodiment, the perovskite film is polycrystalline.

In one embodiment, the large-area perovskite solar cell or module is manufactured by using a large-area perovskite film fabricated by the above-mentioned method.

In one embodiment, the large-area perovskite solar cell or module is applied to both strong and weak-light environment with an illumination of 0.1∼100 mW/cm².

In one embodiment, the electrode layer is made of silver or aluminum.

As mentioned above, the invention utilizes the solution process and anti-solution or Infrared light induced crystallization to rapidly fabricate the large-area perovskite film instead of using the expensive evaporation equipment, so that the manufacturing time and cost can be reduced. In addition, the method of the present invention can control the crystallization rate, crystallization level and grain size of the perovskite film based on the type of the anti-solvent, the applied speed of the anti-solvent, the film immersion time or the intensity, and time of the illumination light thereby a high-quality large-area perovskite film was obtained. Besides, the invention can further precisely control the crystallization rate, crystallization level and grain size of the perovskite film by adjusting the composition and concentration of the precursor solution and the parameters of the film preparation processes, thereby an uniform and high-quality large-area perovskite film can be made. The large-area perovskite film fabricated in the invention can be used as an active layer of the perovskite solar cell or module. The large-area perovskite solar cell or module has an excellent power conversion efficiency and without current hysteresis.

Furthermore, the fabricated large-area perovskite solar cell or module has an excellent power conversion efficiency, and the perovskite has a high absorption coefficient on the visible light region. Accordingly, even in an environment with weak lighting (greater than 0.1 mW/cm²), it can still be applied to charge the battery of the cell phone, electrolyze water to produce hydrogen, or be a power source for a magnetic motor.

### BRIEF DESCRIPTION OF THE DRAWINGS

The invention will become more fully understood from the detailed description and accompanying drawings, which are given for illustration only, and thus are not limitative of the present invention, and wherein:
FIG. 1 is a flow chart of a method of fabricating a large-area perovskite film according to an embodiment of the invention;
FIG. 2A is a schematic diagram showing a solar cell module configured by the large-area perovskite film as an active layer fabricated according to an embodiment of the invention;
FIG. 2B is a flow chart of a method of fabricating a solar cell module configured by the large-area perovskite film as an active layer fabricated according to an embodiment of the invention;
FIG. 3 is a schematic diagram showing perovskite films fabricated by different treating speeds of the anti-solution have different quality;
FIG. 4 is the current density vs. voltage curves of the perovskite solar module fabricated according to a first embodiment of the invention;
FIG. 5 is the current density vs. voltage curves of the perovskite solar module fabricated according to a second embodiment of the invention;
FIG. 6 is the current density vs. voltage curves of the perovskite solar module fabricated according to a third embodiment of the invention;
FIG. 7 is a schematic diagram showing the perovskite solar module of the second embodiment, which is operated under an indoor light source to charge a lithium battery; and
FIG. 8 is a schematic diagram showing the perovskite solar module of the second embodiment, which is operated under an indoor light source to electrolyze water to produce hydrogen and oxygen.

### DETAILED DESCRIPTION OF THE INVENTION

The present invention will be apparent from the following detailed description, which proceeds with the reference to the accompanying drawings, wherein the same references relate to the same elements.

Perovskite is a group of ceramic material having a general chemical formula of ABX₃. Herein, A is at least one of alkali metal ions, CH₃NH₃⁺, and NH₂CH=NH₂⁺, B is at least one of Pb, Sn, and Ge, and X is at least one of halogen (F, Cl, Br or I), PF₆, and SCN.

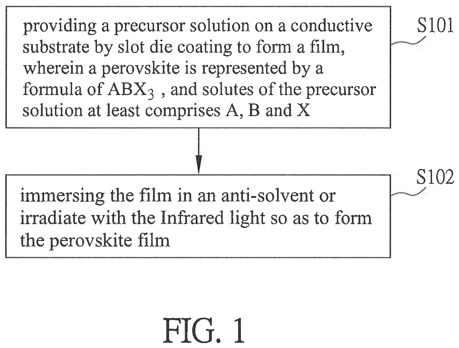

FIG. 1 is a flow chart of a method of fabricating a large-area perovskite film according to an embodiment of the invention. As shown in FIG. 1, the method of fabricating a large-area perovskite film includes the following steps.

The step S101 is to provide a precursor solution on a conductive substrate to form a film, wherein a perovskite is represented by a formula of ABX₃, and solutes of the precursor solution at least comprises A, B and X.

The step S102 is to apply an anti-solvent on the film or irradiate with the Infrared light.

In the steps S101 and S102, the precursor solution and anti-solution can be provided by a proper method other than the evaporation process. For example, the precursor solution can be provided on the conductive substrate by spin coating, slot die coating, ink-jet printing, screen printing, immersing or daubing, and the anti-solution can be applied to the film by spin coating, slot die coating, ink-jet printing, printing, immersing or daubing or the film was treated with the irradiation of Infrared light. Accordingly, the present invention can fabricate the large-area perovskite film without using the evaporation process, so that the expensive evaporation equipment is not needed. Besides, the time for vacuuming the chamber can be saved.

In this embodiment, the solvent of the precursor solution is DMF, DMSO, GBL, or a mixture thereof. The anti-solvent is thiophene and its derivative, iodobenzene, ether, CB, DCB, toluene, benzene, or a mixture thereof. The anti-solvent is just a solvent. The wavelength of the Infrared light is 750 nm ∼ 2000 nm.

For example, in order to fabricate a CH₃NH₃PbI₃ perovskite film, the solvent for the precursor solution thereof is DMF, and the solutes are PbI₂ and CH₃NH₃I (preferably 40 wt%). In addition, the anti-solvent is thiophene. In more detailed, the solute A of the precursor solution includes at least one of alkali metal ions, CH₃NH₃⁺, and NH₂CH=NH₂⁺, the solute B includes at least one of Pb, Sn, and Ge, and the solute X includes at least one of halogen (F, Cl, Br or I), PF₆, and SCN.

To be noted, the applying speed of the anti-solution or Infrared light can affect the quality of the resulting perovskite film. In some cases, if the anti-solution is applied too slowly, the fabricated perovskite film will have bad quality. In other cases, the Infrared illuminating intensity is too low, the fabricated perovskite film will have bad quality. Besides, the manufacturing parameters, such as the composition and concentration of the precursor solution, the spin coating program, the type of the anti-solution, the film immersion time, and the intensity of Infrared light can also affect the quality of the perovskite film. For example, the crystallization speed, crystallization level, or grain size of the perovskite film is affected by these processing parameters. Accordingly, the quality of the perovskite film can be precisely controlled by adjusting the above-mentioned processing parameters.

In the step S101, the precursor solution can be applied on the conductive substrate by spin coating, slot die coating, ink-jet printing, screen printing, immersing or daubing. In practice, a spin coater is utilized to apply the precursor solution on the conductive substrate (spin coating). In one aspect, the precursor solution can also be applied on the conductive substrate through a slot die for performing the slot die coating. In one aspect, a nozzle is utilized to eject the precursor solution on the conductive substrate (ink-jet printing). In one aspect, a screen printer is utilized to print the precursor solution on the conductive substrate. In one aspect, the conductive substrate is immersed in the precursor solution (immersing). In one aspect, a brush or tool is utilized to scribble the precursor solution on the conductive substrate (daubing). In addition, the conductive substrate can be a transparent or an opaque substrate, and it can be a flexible or inflexible substrate. For example, the conductive substrate can be a transparent conductive glass or a flexible transparent conductive substrate.

In the step S102, the anti-solvent can be applied on the film by spin coating, slot die coating, ink-jet printing, printing, immersing or daubing. The generation speed of the perovskite crystals in the film depends on the type of anti-solvent and the applying speed of the anti-solvent. For example, when the anti-solvent is applied on the film by spin coating, the generation speed of the perovskite crystals in the film depends on the speed of the anti-solvent dropped on the film. When the film is immersed in the anti-solvent, the amount of the perovskite crystals grown in the film depends on the time for immersing the film in the anti-solvent.

In the step S102, an Infrared light can be applied on the film.

The perovskite crystals grown in the film are continuously and evenly distributed on the conductive substrate, and the area of the film may be greater than 5 cm². For example, the distribution area of the perovskite crystals is between 5 cm² and 10000 cm². In this case, the area of the conductive substrate is also greater than 5 cm (e.g. between 5 cm² and 10000 cm²).

In this embodiment, the large-area and uniform perovskite (ABX₃) film is rapidly fabricated by solution process and anti-solution or Infrared light induced crystallization. The applied anti-solvent or Infrared light can induce the film, which is made by the precursor solution, to generate perovskite crystals. In more detailed, the film made from the precursor solution contains the perovskite components. The solvent of the film can be replaced, after contacting with the anti-solvent, by the anti-solvent to generate the perovskite crystals. The solvent of the film will evaporate after irradiating with the Infrared light. If the anti-solvent (or Infrared light) is continuously applied to all over the film, the perovskite crystals can be continuously generated at the whole film. Accordingly, the film can be transformed into a continuous and homogeneous perovskite film. In this embodiment, the perovskite crystals of the film are polycrystalline.

In addition, the method of fabricating a large-area perovskite film may further include an annealing step, which is to anneal the film at 100 °C for 20 minutes or heating with Infrared irradiation. This annealing step can further help the growth of the perovskite crystals. In practice, the generated perovskite film, after applying the anti-solvent or Infrared light, can be recrystallized in the annealing step, so that the grain size of the perovskite film increased.

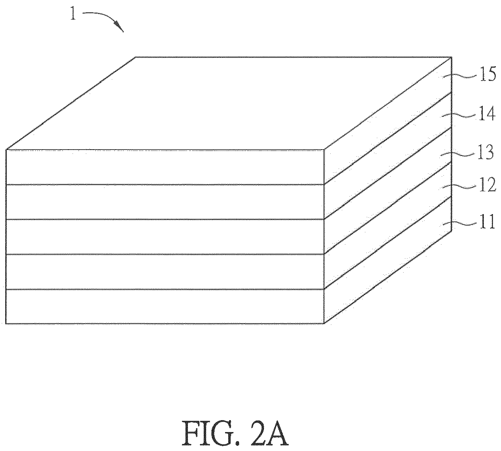

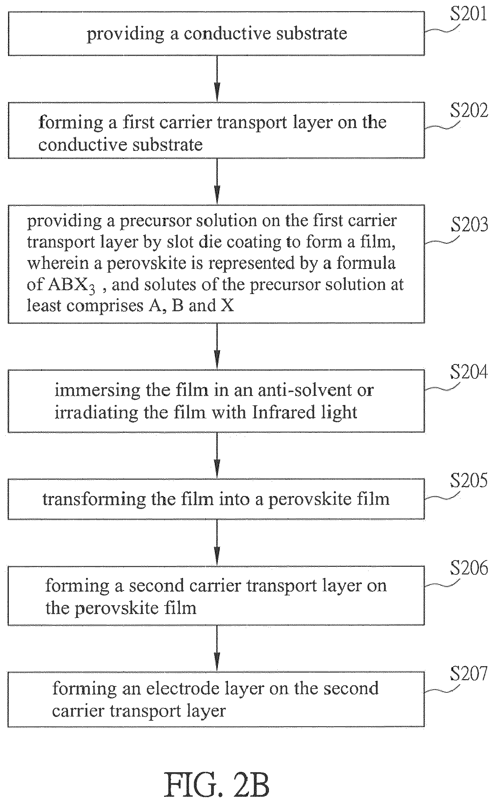

FIG. 2A is a schematic diagram showing a solar cell or module configured by using the large-area perovskite film as an active layer prepared according to an embodiment of the invention, and FIG. 2B is a flow chart of a method for fabricating a solar cell or module configured by using the large-area perovskite film as an active layer prepared according to an embodiment of the invention.

Referring to FIG. 2A, the solar module 1 of this embodiment has an active layer 13, which can be fabricated by the above-mentioned method (see FIG. 1). In fact, when the solar light enters the solar module 1 and is absorbed by the active layer 13, the active layer 13 will generate electron-hole pairs or free carriers. The number, moving speed and binding status of the electron-hole pairs or free carriers are the key factors determining the output current of the solar module 1. Therefore, the material characteristics and quality of the active layer 13 can highly affect the PCE (power conversion efficiency) of the solar module 1.

With reference to FIG. 2A and FIG. 2B, the solar module 1 of this embodiment has an inverted structure, but this invention is not limited thereto. Firstly, a conductive substrate 11 is provided (step S201). The conductive substrate 11 can be a transparent conductive substrate, and preferably a transparent conductive glass, which can be for example but not limited to the ITO (indium doped tin oxide) glass, FTO (fluorine doped tin oxide) glass, or other transparent conductive substrate. Of course, the conductive substrate 11 can be a flexible transparent conductive substrate.

Next, a first carrier transporting layer 12 is formed on the conductive substrate 11 by spin coating or other methods (step S202). Since the solar module 1 of this embodiment has an inverted structure, the first carrier transporting layer 12 is a hole transporting layer, which can be PEDOT:PSS or any suitable material that can transport holes.

Afterwards, the step S203 is to provide a precursor solution on the first carrier transporting layer 12 to form a film. The solutes of the precursor solution includes PbI₂ and CH₃NH₃I (40 wt%), and the solvent thereof is DMF. For example, the precursor solution can be provided on the first carrier transporting layer 12 by spin coating (3000 RPM for 50 seconds) so as to form the film. Then, the step S204 is to immerse the film in the anti-solvent or irradiate the film with Infrared light at the last second of the spin. In the step S204, the anti-solvent can replace the solvent containing in the film. In this embodiment, the anti-solvent is thiophene. In the step S205, after anti-solvent dropping and/or thermal annealing, the film transformed into a high quality CH₃NH₃PbI₃ film. The obtained perovskite film can be used as the active layer 13 of the solar module 1.

In this embodiment, the perovskite film is a continuous and homogeneous film, and the area of the film is greater than 5 cm² (e.g. between 5 cm² and 10000 cm²). In addition, the steps S203 to S205 are similar to the steps S101 to S102, so the manufacturing processes for the steps S203 to S205 can be referred to the above-mentioned processes of the steps S101 to S102.

Next, a second carrier transporting layer 14 is formed on the perovskite film (the active layer 13) by spin coating, thermal evaporation or other methods (step S206). Since the solar module 1 of this embodiment has an inverted structure, the second carrier transporting layer 14 is an electron transporting layer, which can be made of 6,6-phenyl-C61-butyric acid methyl ester (PC₆₁BM), 6,6-phenyl-C71-butyric acid methyl ester (PC₇₁BM0, indene-C60 bisadduct (ICBA), C₆₀, C₇₀, fullerene derivatives, LiF, Ca, TiO₂, bathocuproine (BCP), ZrO, ZnO, Polyethylenimine (PEI), poly[(9,9-bis(3'-(N,N-dimethylamino)propyl)-2,7-fluorene)-alt-2,7-(9,9-dioctyl-fluore ne) (PFN), or any suitable material that can transport electrons.

Finally, an electrode layer 15 is formed on the second carrier transporting layer 14 by evaporation or other methods (step S207). Since the solar module 1 of this embodiment has an inverted structure, the electrode layer 15 is a cathode, which can be made of Ca, Al, Ag, Pd, Au or their combinations.

In another aspect, the solar module 1 has a regular structure. In this aspect, the first carrier transporting layer 12 is an electron transporting layer, which can be made of TiO₂, ZnO, poly[(9,9-bis(3'-(N,N-dimethylamino)propyl)-2,7-fluorene)-alt-2,7-(9,9--dioctyl-fluorene) (PFN), polyethylenimine (PEI), ZrO, or any suitable material that can transport electrons. The second carrier transporting layer 14 is a hole transporting layer, which can be made of V₂O₅, 2,2',7,7'-Tetrakis[N,N-di(4-methoxy-phenyl)amino]-9,9'-spiro-bifluorene (Spiro -OMeTAD), NiOₓ, In₂O₃, WO₃, MoO₃, or any suitable material that can transport holes. The electrode layer 15 is an anode, which can be made of Ag or Au.

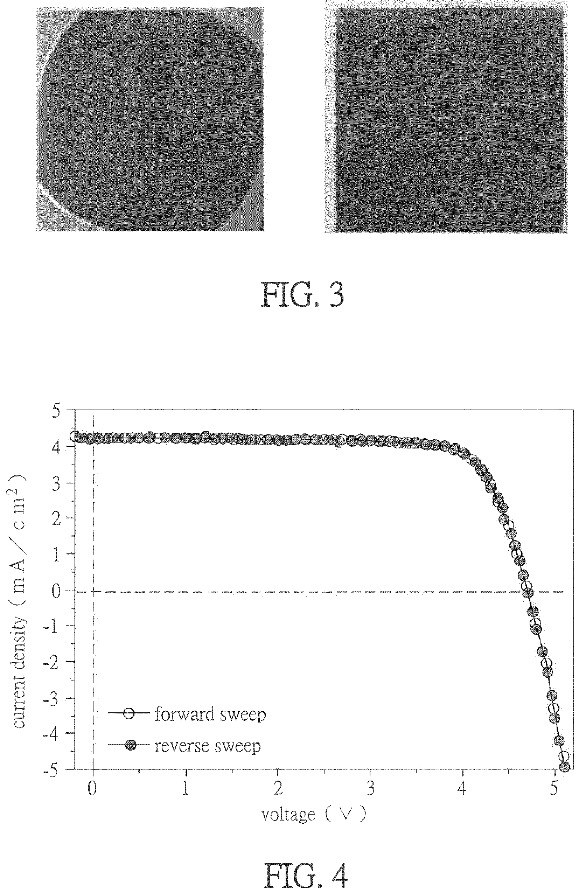

FIG. 3 shows the photos of perovskite films fabricated by different dropping speeds of the anti-solution. In the left photo, the perovskite film is fabricated with a slow dropping of the anti-solution. In the right photo, the perovskite film is fabricated with a fast dropping of the anti-solution.

FIG. 4 is the current density vs. voltage curves of the perovskite solar module fabricated according to a first embodiment of the invention. Referring to FIG. 4 in view of FIG. 2A, the conductive substrate 11 is an ITO/glass substrate with an area of 25 cm², and the first carrier transporting layer 12 is made of PEDOT:PSS. CH₃NH₃I+PbI₂/DMF solution (30wt%) is applied by slot die coating so as to form a film, and the film is immersed in an anti-solvent (thiophene) to form a perovskite film, thereby obtaining ITO/PEDOT:PSS/perovskite film. The perovskite film is used as the active layer 13. Then, the PCBM (30 nm) is deposited on ITO/PEDOT:PSS/ perovskite to form the second carrier transporting layer 14. Finally, the silver is evaporated on the second carrier transporting layer 14 to form the electrode layer 15, thereby obtaining the perovskite solar module (6% efficiency). In addition, it is possible to adjust the concentration of the precursor solution, the coating speed, immersion conditions, and the materials of the electron and hole transporting layers so as to optimize the perovskite solar module to achieve a short circuit current density of 4.26 mA/cm², an open circuit voltage of 4.69 V, a fill factor (FF) of 0.77, and a PCE of 15.43%. FIG. 4 is the current density vs. voltage curves of this perovskite solar module.

As shown in the following table, compared with the conventional perovskite solar cell or module, the perovskite solar cell or module of the present invention configured with an active layer of the above-mentioned large-area perovskite film has better PCE and higher FF. Besides, compared with the conventional perovskite solar cell or module, the perovskite solar cell or module of the present invention does not have the current hysteresis as the curves shown in FIG. 4.

| perovskite solar cell module | Area of active layer (cm²) | PCE (%) | FF |
|---|---|---|---|
| Conventional | 4 | 12.6 | 0.69 |
| Present invention | 11 | 15.4 | 0.77 |

Conventional: W. Qiu,T. Merckx,a M. Jaysankar, C. Masse de la Huerta, L. Rakocevic, W. Zhang, U. W. Paetzold, R. Gehlhaar,a L. Froyen,b J. Poortmans, D. Cheyns, H. J. Snaith and P. Heremans. Pinhole-free perovskite films for efficient solar modules._Energy Environ. Sci., 2016, 9, 484-489.

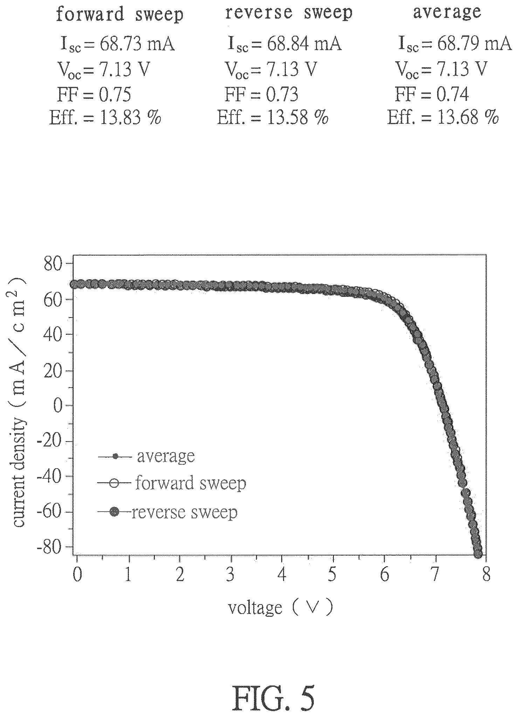

FIG. 5 is the current density vs. voltage curves of the perovskite solar module fabricated according to a second embodiment of the invention. Referring to FIG. 5 in view of FIG. 2A, the conductive substrate 11 is an ITO substrate, and the first carrier transporting layer 12 is made of PEDOT:PSS and deposited on the ITO substrate (100 cm²). Then, a film is formed on the ITO/PEDOT:PSS by spin coating (3000 rpm for 60 seconds) of the precursor solution (containing 0.35 M MAPbI₃, 0.35 M MABr, and 0.4 M MAC1 in DMSO). Afterwards, at the last two seconds of spin coating of the precursor solution, the anti-solvent (iodobenzene) is applied on the spin-coated film. Then, the film is heated (annealed) at 100 °C for 30 seconds to obtain a uniform CH₃NH₃PbClₓBr_{y}I_{z} film. Herein, the CH₃NH₃PbClₓBr_{y}I_{z} film is used as the active layer 13. Then, C₆₀ is evaporated on CH₃NH₃PbClₓBr_{y}I_{z} film to form the second carrier transporting layer 14. Finally, the aluminum is evaporated on the second carrier transporting layer 14 to form the electrode layer 15, thereby obtaining the perovskite solar module (4% efficiency). In addition, it is possible to adjust the ratios and concentrations of MAPbI₃, MABr and MACl, the spin coating program, and the materials of the electron transporting layer and the electrode layer to fabricate a perovskite solar module, which has an active area of 27 cm², to achieve a short circuit current density of 2.55 mA/cm², an open circuit voltage of 7.13 V, a fill factor (FF) of 0.75, and a PCE of 13.83%. FIG. 5 is the current density vs. voltage curves of this perovskite solar module, which also indicates that this perovskite solar module does not have the current hysteresis.

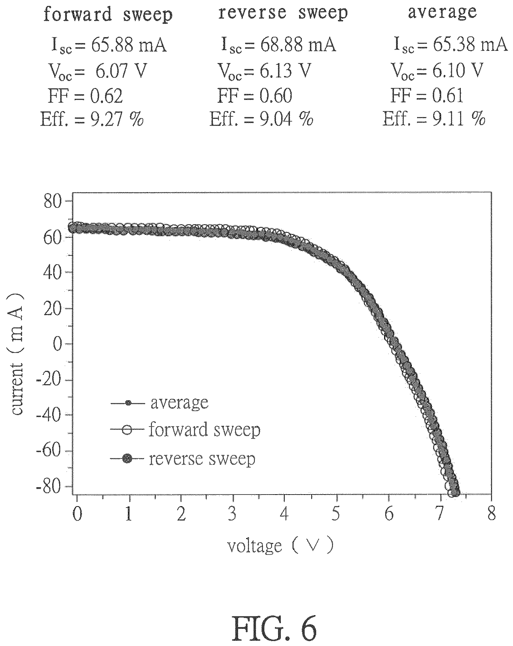

FIG. 6 is the current density vs. voltage curves of the perovskite solar module fabricated according to a third embodiment of the invention. Referring to FIG. 6 in view of FIG. 2A, the conductive substrate 11 is an ITO/PET substrate (100 cm²), and the first carrier transporting layer 12 is made of PEDOT:PSS and deposited on the ITO/PET substrate. Then, a film is formed on the ITO/PEDOT:PSS by spin coating (3000 rpm for 60 seconds) of the precursor solution (containing 0.35 M MAPbI₃, 0.35 M MABr, and 0.4 M MACl in DMF). Afterwards, at the last two seconds of the spin coating the precursor solution, the anti-solvent (iodobenzene) is applied on the film. Then, the film is heated (annealed) at 100 °C for 30 seconds so as to obtain a uniform CH₃NH₃PbClₓBr_{y}I_{z} film. Herein, the CH₃NH₃PbClₓBr_{y}I_{z} film is used as the active layer 13. Then, the material C₆₀ is evaporated on CH₃NH₃PbClₓBr_{y}I_{z} to form the second carrier transporting layer 14. Finally, the aluminum is evaporated on the second carrier transporting layer 14 to form the electrode layer 15, thereby obtaining the flexible perovskite solar module (2% efficiency). In addition, it is possible to adjust the ratios and concentrations of PbI₂, MAI, MABr and MACl, the spin coating parameters, the anti-solvent applied method, and the materials of the electron transporting layer and the electrode layer to fabricate a perovskite solar module, which has an active area of 27 cm², to achieve a short circuit current density of 2.44 mA/cm², an open circuit voltage of 6.07 V, a fill factor (FF) of 0.62, and a PCE of 9.27%. FIG. 6 is the current density vs. voltage (I-V) curves of this perovskite solar module, the I-V curves indicates that this perovskite solar module does not have obvious current hysteresis.

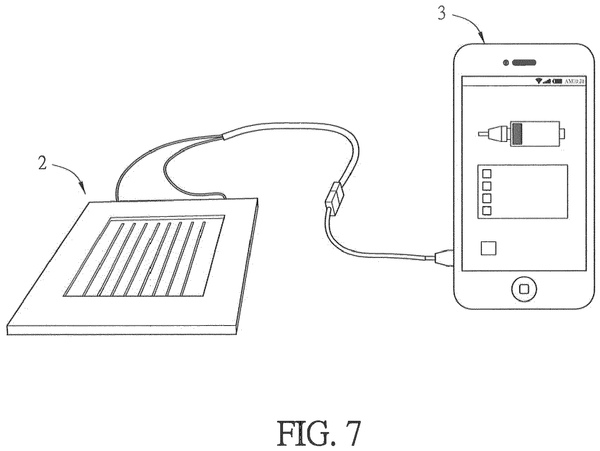

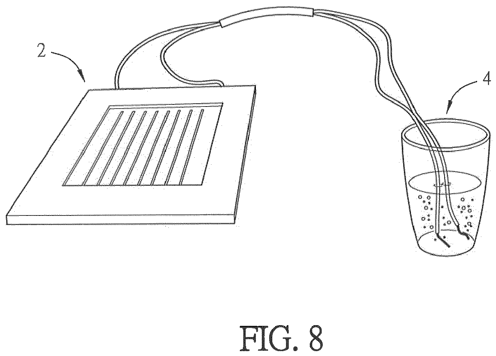

The perovskite solar module made of the above-mentioned fabricating method contains a high quality, large-area perovskite film functioned as the active layer. Accordingly, even in an environment with weak light source (0.1∼100 mW/cm²), it can still generate sufficient current and voltage to charge the battery of a cell phone, electrolyze water to produce hydrogen, or as a power source for a magnetic motor. As shown in FIG. 7, the perovskite solar module 2 can be applied to charge the lithium battery of a cell phone 3 under an indoor lighting. As shown in FIG. 8, the perovskite solar module 2 can be applied to electrolyze water to produce hydrogen and oxygen under an indoor lighting.

In summary, the invention utilizes the solution process and anti-solution crystallization to rapidly fabricate the large-area perovskite film instead of using the expensive evaporation equipment, so that the manufacturing time and cost can be reduced. In addition, the method of the present invention can control the crystallization rate, crystallization level and grain size of the perovskite film based on the type of the anti-solvent, the applied speed of the anti-solvent, the film immersion time or the Infrared light illumination intensity and time, thereby a high-quality large-area perovskite film can be made. Besides, the invention can further precisely control the crystallization rate, crystallization level and grain size of the perovskite film by adjusting the composition and concentration of the precursor solution and the parameters of the spin coating or immersion processes as well as the light illumination intensity and time, thereby the uniform and high-quality large-area perovskite film was fabricated. The large-area perovskite film fabricated by the invention can be used as the active layer of the solar cell or module. The large-area perovskite solar cell or module has an excellent power conversion efficiency and without current hysteresis.

Furthermore, the large-area perovskite solar cell or module has an excellent power conversion efficiency, and the perovskite has a strong absorption in the visible light. Accordingly, even in an environment with weak lighting (0.1∼100 mW/cm²), it can still be applied to charge the battery of a cell phone, electrolyze water to produce hydrogen, or be a power source for a magnetic motor.

Although the invention has been described with reference to specific embodiments, this description is not meant to be construed in a limiting sense. Various modifications of the disclosed embodiments, as well as the alternative embodiments, will be apparent to persons skilled in the art. It is, therefore, contemplated that the appended claims will cover all modifications that fall within the true scope of the invention.

## Claims

1. A method of fabricating a perovskite film, comprising steps of:
providing a precursor solution on a conductive substrate by slot die coating to form a film, wherein a perovskite is represented by a formula of ABX₃, and solutes of the precursor solution at least comprises A, B and X; and immersing the film in an anti-solvent so as to form the perovskite film;
wherein perovskite crystals of the perovskite film are continuously and evenly distributed on the conductive substrate, and areas of the perovskite film and the conductive substrate are 5∼10000 cm².

2. The method of claim 1,
wherein the anti-solvent induces the film to generate perovskite crystals; and
wherein, A is at least one of alkali metal ions, CH₃NH₃⁺, and NH₂CH= NH₂⁺, B is at least one of Pb, Sn, and Ge, and X is at least one of halogen (F, Cl, Br or I), PF₆, and SCN.

3. The method of claim 1, wherein a solvent of the precursor solution is DMF, DMSO, GBL, or a mixture thereof.

4. The method of claim 1, wherein the anti-solvent is thiophene and its derivative, iodobenzene, ether, chlorobenzene, dichlorobenzene, toluene, benzene, or a mixture thereof.

5. The method of claim 1, further comprising a step of:
annealing the film so as to grow bigger perovskite grains.

6. The method of claim 1, wherein the film is immersed in the anti-solvent so as to apply the anti-solvent on the film, and an amount of perovskite crystals generated in the film depends on an immersion time of the film in the anti-solvent.

7. A method of fabricating a perovskite film, comprising steps of:
providing a precursor solution on a conductive substrate by slot die coating to form a film, wherein a perovskite is represented by a formula of ABX₃, and solutes of the precursor solution at least comprises A, B and X; and irradiating an Infrared light on the film so as to form the perovskite film;
wherein perovskite crystals of the perovskite film are continuously and evenly distributed on the conductive substrate, and areas of the perovskite film and the conductive substrate are 5∼10000 cm².

8. The method of claim 7,
wherein, A is at least one of alkali metal ions, CH₃NH₃⁺, and NH₂CH= NH₂⁺, B is at least one of Pb, Sn, and Ge, and X is at least one of halogen (F, Cl, Br or I), PF₆, and SCN.

9. The method of claim 7, wherein a solvent of the precursor solution is DMF, DMSO, GBL, or a mixture thereof.

10. The method of claim 7,
wherein the Infrared light used to induce the film to generate the perovskite crystals has a wavelength between 750 ∼ 2000 nm.

11. The method of claim 7, further comprising a step of:
annealing the film so as to grow the perovskite crystals.

12. A method of fabricating a perovskite solar cell or module, comprising steps of:
providing a conductive substrate;
forming a first carrier transporting layer on the conductive substrate;
providing a precursor solution on the first carrier transporting layer by slot die coating to form a film, wherein a perovskite is represented by a formula of ABX₃, and solutes of the precursor solution at least comprises A, B and X;
immersing the film in an anti-solvent or irradiated with Infrared light.;
transforming the film into a perovskite film;
annealing the film to grow bigger perovskite grains;
forming a second carrier transporting layer on the perovskite film; and
forming an electrode layer on the second carrier transporting layer;
wherein perovskite crystals of the perovskite film are continuously and evenly distributed on the conductive substrate, and areas of the perovskite film and the conductive substrate are 5∼10000 cm².

13. The method of claim 12,
wherein the conductive substrate is a transparent conductive glass or a flexible transparent conductive substrate;
wherein the first carrier transporting layer is a hole transporting layer or an electron transporting layer, while the second carrier transporting layer is an electron transporting layer or a hole transporting layer, and the electrode layer is a cathode layer or an anode layer;
wherein the hole transporting layer comprises one or any combinations of PEDOT:PSS, V₂O₅, NiO, In₂O₃, graphene, MoS, MoSe, Spiro-OMeTAD, polyalkyl-thiophene, and MoO₃;
wherein the electron transporting layer comprises one or any combinations of 6,6-phenyl-C61-butyric acid methyl ester (PC₆₁BM), 6,6-phenyl-C71-butyric acid methyl ester, (PC₇₁BM), Indene-C60 bisadduct (ICBA), C₆₀, C₇₀, LiF, Ca, TiO₂, Bathocuproine (BCP), ZrO, ZnO, polyethylenimine (PEI), and poly[(9,9-bis(3'-(N,N-dimethylamino)propyl)-2,7-fluorene)-alt-2,7- (9,9-dioctyl-fluorene) (PFN); and
wherein the electrode layer comprises one or any combinations of Ca, Al, Ag, Pd, and Au.

14. A perovskite solar cell or module, comprising:
a conductive substrate having an area ranged from 5 cm² to 10000 cm²;
a first carrier transporting layer deposited on the conductive substrate;
a perovskite film having a continuous and homogeneous morphology, wherein an area of the film is greater than 5 cm²;
a second carrier transporting layer deposited on the perovskite film; and
an electrode layer deposited on the second carrier transporting layer.

15. The perovskite solar cell or module of claim 14, wherein the perovskite film in the cell or module is polycrystalline.

16. The perovskite solar cell or module of claim 14, which is applied to an environment with an illumination of 0.1∼100 mW/cm².

17. The perovskite solar cell or module of claim 14, wherein the electrode layer is made of silver.
